# EUROPÄISCHE PATENTSCHRIFT

(11) **EP 1 983 467 B1**
(45) Veröffentlichungstag und Bekanntmachung des Hinweises auf die Patenterteilung: **13.03.2013**
(21) Anmeldenummer: 07106472.9
(22) Anmeldetag: 19.04.2007
(51) Int. Cl.: G06K 7/00, G06K 19/077, H01Q 1/00, G08C 17/02, H04B 1/02, H04B 1/59, H05K 1/14, H05K 1/18, H01Q 1/12, H01Q 1/22, H01Q 1/38

(54) **Datenträger-/Sendevorrichtung und Verfahren zu ihrer Herstellung**
Data carrier/transmission device and method for manufacturing it
Dispositif de support de données/émission et procédé destiné à sa fabrication

(43) Veröffentlichungstag der Anmeldung: 22.10.2008
(60) Teilanmeldung: 11162585.1
(73) Patentinhaber: BALLUFF GmbH, 73765 Neuhausen (DE)
(72) Erfinder: Reuker, Dieter, 70619 Stuttgart (DE); Höhn, Claus, 72657 Altenriet (DE)
(74) Vertreter: Hoeger, Stellrecht & Partner Patentanwälte

(56) Entgegenhaltungen:
- WO-A-2004/066438
- WO-A-2006/131313
- DE-A1- 19 961 488
- DE-U1-202004 016 751
- US-A- 5 870 065
- US-A- 6 050 622
- US-A1- 2004 056 816
- US-A1- 2005 162 331
- US-A1- 2005 179 552
- US-A1- 2005 248 460

## Beschreibung

Die Erfindung betrifft eine Datenträger-/Sendevorrichtung gemäß Oberbegriff von Anspruch 1.

Datenträger-/Sendevorrichtungen werden eingesetzt, um beispielsweise Objekte zu identifizieren. Die Datenträger-/Sendevorrichtung umfasst einen Schwingkreis, mittels welchem ein Transponder gebildet ist, über den Daten berührungslos und ohne Sichtkontakt gelesen und auch gespeichert werden. Über eine Sende-Empfangs-Einheit, welche einen Sender umfasst, können gespeicherte Daten automatisch und schnell identifiziert werden.

In der nicht vorveröffentlichten DE 10 2006 017 992 A1, als EP 1 843 281 veröffentlicht und relevant nach Art. 54 (3) EPÜ, ist eine

Datenträger-/Sendevorrichtung zur Fixierung an einem Objekt beschrieben, welche einen Schwingkreis mit mindestens einer Spule, eine elektrische Schaltungsanordnung, an welche die mindestens eine Spule gekoppelt ist, und eine Fixierungseinrichtung mit einer Anlageseite an das Objekt umfasst. Die Spulenachse der mindestens einen Spule ist dabei mindestens näherungsweise parallel zu der Anlageseite der Fixierungseinrichtung.

Aus der US 6,050,622 ist ein Sicherheitssiegel bekannt, welches einen flexiblen Träger aufweist und mindestens einen Klebefilm, welcher auf dem Träger angeordnet ist. Auf der einen Seite des Trägers ist ein elektronischer Schaltkreis angeordnet, welcher einen Leitpfad aufweist, der eine Spule bildet.

Aus der US 2005/0179552 A1 ist ein RFID-Tag bekannt, welcher eine Antenne in Form einer Spule aufweist.

Aus der US 2005/0248460 A1 ist ein passiver integrierter Transponder-Tag bekannt, welcher einen integrierten Schaltkreis und einen Kern aufweist. Der Kern umfasst einen spulenbildenden Bereich und einen Träger für einen integrierten Schaltkreis.

Aus der US 2004/0056816 A1 ist eine Ferritkernantenne auf PCB-Basis bekannt. Die Spuren der PCBs bilden die Windungen für die Antenne und PCB-Lagen halten einen Ferritkern für die Windungen in Position.

Aus der US 2005/0162331 A1 ist eine Lese-/Schreibantenne bekannt, bei der eine weichmagnetischer Körper auf einer Oberfläche angeordnet ist und welcher zur Anordnung mindestens einer Windung dient. Die Ansprüche sind gegen dieses Dokument abgegrenzt.

Die DE 42 21 305 A1 und die DE 20 2004 016 751 U1 beschreiben weitere dreidimensionale Antennenanordnungen für Transponder.

Der Erfindung liegt die Aufgabe zugrunde, eine Datenträger-/Sendevorrichtung, der eingangs genannten Art bereitzustellen, welche auf einfache Weise herstellbar ist.

Die Erfindung ist durch Anspruch 1 definiert.

Ausführungsbeispiele sind in den abhängigen Ansprüchen dargestellt.

Durch die erfindungsgemäße Lösung lässt sich eine 3D-Spule durch 2D-Verfahren herstellen. Die ersten Bereiche der Spule lassen sich an dem Trägerkörper durch Oberflächenbearbeitung wie Drucken oder Laseraktivierung herstellen. Die zweiten Bereiche lassen sich auf einfache Weise beispielsweise durch Bonden herstellen.

Durch die erfindungsgemäße Lösung ist es möglich, die Spule und auch die gesamte Datenträger-/Sendevorrichtung ohne Lötstellen herzustellen. Weiterhin muss keine Spule gewickelt werden. Es müssen keine Drahtenden bei der Spulenherstellung gefangen werden und es wird keine Wickelmaschine benötigt.

Die Fertigung lässt sich vereinfachen, da weniger Prozesschritte notwendig sind. Weiterhin ist der Montageaufwand stark verringert und man erhält eine hohe Reproduzierbarkeit.

Eine erfindungsgemäße Datenträger-/Sendevorrichtung kann als reine Datenträgervorrichtung eingesetzt werden, aus welcher nur Daten auslesbar sind. Sie kann auch als Datenträger-/Sendevorrichtung eingesetzt werden, aus welcher Daten auslesbar sind und welche neu beschreibbar ist.

Es sind an dem Trägerkörper Brücken gebildet, an welchen die zweiten Bereiche angeordnet oder gebildet sind. Durch die Positionierung der zweiten Bereiche an den Brücken ragen diese über den Trägerkörper hinaus und liegen oberhalb von ihm. Die Brücken lassen sich auf einfache Weise beispielsweise mittels Spritzguss herstellen. Insbesondere können diese einstückig mit dem Trägerkörper gebildet werden. Beispielsweise können in MID-Verfahren die Brücken an dem Trägerkörper hergestellt werden und die entsprechenden ersten Bereiche und zweiten Bereiche werden, wenn ein geeignetes Material für den Trägerkörper verwendet wird, durch Laseraktivierung hergestellt.

Ein erster Bereich und der zugeordnete zweite Bereich einer Windung sind elektrisch leitend miteinander verbunden. Der erste Bereich und der zweite Bereich sind auch mechanisch miteinander verbunden. Dadurch erhält man eine Windung, welche sich aus dem ersten Bereich und dem zweiten Bereich zusammensetzt. Dadurch wiederum lässt sich eine Spule mit mehreren Windungen realisieren.

Der erste Bereich einer Windung ist mit dem zweiten Bereich einer benachbarten Windung elektrisch leitend verbunden. Es lassen sich dadurch benachbarte Windungen auf einfache Weise miteinander verbinden, ohne dass die Wicklung einer Spule notwendig ist.

Aus dem gleichen Grund ist es günstig, wenn der zweite Bereich einer Windung mit dem ersten Bereich einer benachbarten Windung elektrisch leitend verbunden ist.

Günstig ist es, wenn die ersten Bereiche in der Form von Leiterbahnen auf den Trägerkörper gebildet sind. Es lässt sich dadurch ein Trägerkörper beispielsweise in Form einer Platine auf einfache Weise herstellen. Wenn Leiterbahnen für den Anschluss der elektrischen Schaltung hergestellt werden, dann lassen sich die entsprechenden ersten Bereiche über Leiterbahnen integral mitherstellen. Dadurch erhält man eine einfache und kostengünstige Herstellung. Die Leiterbahnen lassen sich durch 2d-Verfahren und insbesondere durch Oberflächenbearbeitung wie Bedrucken oder Laseraktivieren herstellen.

Günstig ist es, wenn der Trägerkörper eine Oberseite aufweist, an welcher die ersten Bereiche der Windungen gebildet sind. Die Oberseite, an welcher die Bereiche der Windungen gebildet sind, muss dabei nicht die endgültige Oberfläche sein. Es ist auch möglich, dass nach Herstellung der ersten Bereiche diese zu der Oberfläche hin abgedeckt werden.

Es ist insbesondere günstig, wenn die Oberseite flach ist. Es lassen sich dann die ersten Bereiche auf einfache Weise herstellen.

Ganz besonders vorteilhaft ist es, wenn die ersten Bereiche durch Oberflächenbearbeitung an dem Trägerkörper hergestellt sind. Dadurch ergibt sich eine einfache und kostengünstige Fertigung. Insbesondere lässt sich integral mit der Herstellung von Leiterbahnen zum Anschluss der elektronischen Schaltungsanordnung ein Teil der Spule, nämlich die ersten Bereiche, herstellen.

Beispielsweise werden die ersten Bereiche gedruckt oder, wenn ein MID-Verfahren verwendet wird, durch Laseraktivierung hergestellt. Im letzteren Falle wird für den Trägerkörper ein Material verwendet, an welchem sich durch Laseraktivierung eine Leiterbahn herstellen lässt.

Günstig ist es, wenn an dem Trägerkörper eine oder mehrere Leiterbahnen zum Anschluss an äußere Windungen angeordnet sind. Diese Leiterbahnen werden dabei auf grundsätzlich die gleiche Weise hergestellt wie die ersten Bereiche.

Aus dem gleichen Grund ist es günstig, wenn an dem Trägerkörper eine oder mehrere Leiterbahnen zur Verbindung der mindestens einen Spule mit der elektrischen Schaltungsanordnung angeordnet sind. Dadurch lässt sich der Trägerkörper mit den Leiterbahnen auf einfache Weise "integral" herstellen. Sowohl die ersten Bereiche als auch die Anschluss-Leiterbahnen sind in den Trägerkörper integriert.

Es ist dabei günstig, wenn die ersten Bereiche parallel beabstandet sind, um entsprechende Teilwindungen zu erhalten.

Ganz besonders vorteilhaft ist es, wenn die ersten Bereiche jeweils mindestens ein erstes Anschlussfeld umfassen. Vorzugsweise umfassen die ersten Bereiche ein erstes Anschlussfeld und ein zweites Anschlussfeld, wobei sich zwischen den beiden Anschlussfeldern eine Leiterbahn erstreckt. Über die Anschlussfelder lassen sich Windungen herstellen, indem ein elektrischer Kontakt über ein Verbindungselement hergestellt wird. Beispielsweise sind dazu Bonddrähte vorgesehen. Über die Anschlussfelder lässt sich auf einfache Weise eine mechanische und elektrisch leitende Verbindung herstellen. Insbesondere ist eine Bonding-Verbindung möglich.

Günstig ist es, wenn an dem Trägerkörper mindestens ein Spulenkernkörper beispielsweise aus einem Ferritmaterial angeordnet ist. Der Spulenkernkörper dient zur "Sammlung" und "Fokussierung" von Feldlinien, um einen großen Ansprechabstand zu erhalten. Der Spulenkernkörper ist aus einem weichmagnetischen Material hergestellt.

Ganz besonders vorteilhaft ist es, wenn der Spulenkernkörper quaderförmig ist. Dadurch lassen sich Datenträger-/Sendevorrichtungen mit geringen Höhenabmessungen bilden.

Die erfindungsgemäße Datenträger-/Sendevorrichtung lässt sich auf einfache und kostengünstige Weise fertigen, wenn der mindestens eine Spulenkernkörper auf den Trägerkörper aufgeklebt ist. Der Aufwand zur Fixierung des Spulenkernkörpers an dem Träger lässt sich dadurch gering halten.

Es ist dann fertigungstechnisch günstig, wenn die Brücken einstückig an dem Trägerkörper gebildet sind. Dadurch erhält man einen Trägerkörper mit integrierten Brücken, welcher in einem Schritt hergestellt werden kann.

Insbesondere ist dann der Trägerkörper durch Spritzgießen hergestellt.

Günstig ist es, wenn der Trägerkörper plattenförmig ausgebildet ist. Dadurch lässt sich die Spule flach ausbilden mit geringer Höhe über den Trägerkörper hinaus.

Es hat sich als günstig erwiesen, wenn der Träger eine Metallelementeinrichtung aufweist, welche die mindestens eine Spule zu einem Objekt hin abdeckt, wenn der Träger an dem Objekt fixiert ist. Durch eine solche Metallelementeinrichtung wird die Resonanzfrequenz des Schwingkreises verschoben und zwar üblicherweise zu höheren Frequenzen hin. Wenn die Datenträger-/Sendevorrichtung eine Metallelementeinrichtung enthält, dann erhält man dadurch eine "intrinsische" Resonanzverschiebung. Dadurch wird der Einfluss des externen metallischen Objekts verringert, da die durch das externe metallische Objekt verursachte Resonanzverschiebung stark verringert ist. Dies trägt dazu bei, dass sich ein relativ hoher Ansprechabstand (Abstand zwischen dem Objekt, welches mit der Datenträger-/Sendevorrichtung versehen ist, und einer Sende-Empfangs-Einrichtung) ergibt. Es wird in diesem Zusammenhang auf die nicht vorveröffentlichte deutsche Anmeldung Nr. 10 2006 017 992.7 vom 7. April 2006 verwiesen.

Die Metallelementeinrichtung ist beispielsweise plattenförmig oder folienförmig. Sie kann an dem Trägerkörper angeordnet sein oder in diesen integriert sein und selber Teil des Trägerkörpers sein.

Es ist auch möglich, dass die Metallelementeinrichtung ein Feld von beabstandeten metallischen Bereichen aufweist. Die metallischen Bereiche und Kanäle, welche zwischen den metallischen Bereichen liegen, sind so gewählt, dass eine geeignete intrinsische Resonanzverschiebung erreicht wird. Wenn die Metallelementeinrichtung diskrete Felder aufweist und nicht kontinuierlich ist, lässt sich diese unter Umständen (insbesondere im Zusammenhang mit MID-Verfahren) einfacher herstellen.

Günstigerweise ist eine Rückseite des Trägers, welche von der mindestens einen Spule abgewandt ist, mindestens teilweise metallisch. Dadurch lässt sich die geschilderte intrinische Resonanzverschiebung erreichen.

Günstig ist es, wenn die mindestens eine Spule eine minimierte Anzahl von Windungen aufweist und insbesondere höchstens zehn Windungen aufweist. Dadurch erhält man einen optimierten Ansprechabstand. Beispielsweise sind sechs Windungen vorgesehen.

Es ist günstig, wenn eine Windungsachse der mindestens einen Spule parallel zu einer Oberseite des Trägerkörpers ist. Durch diese Ausrichtung der mindestens einen Spule ist die Spulenachse mindestens näherungsweise parallel zu einem Oberflächenbereich eines Objekts, an welchem die Datenträgervorrichtung über eine Anlageseite fixiert ist. Feldlinien (insbesondere des induktiven Felds) einer Sende-Empfangs-Einrichtung verlaufen dann im Wesentlichen parallel zur Oberfläche des metallischen Objekts. Dadurch wird das Feld vor dem Objekt verdichtet und es ergibt sich ein relativ großer Ansprechabstand. Es lässt sich so beispielsweise gewährleisten, dass bei der Vorbeiführung von metallischen Objekten, welche mit der entsprechenden Datenträger-/Sendevorrichtung versehen sind, an einem Lesekopf der Lesekopf nicht auf das Objekt zu bewegt werden muss, um Daten auslesen zu können. Es wird in diesem Zusammenhang auf die nicht vorveröffentlichte deutsche Patentanmeldung Nr. 10 2006 017 992.7 verwiesen.

Günstig ist es, wenn die elektrische Schaltungsanordnung einen IC umfasst und insbesondere im Wesentlichen durch einen solchen IC gebildet ist. Dadurch ergibt sich ein kompakter Aufbau.

Günstigerweise ist dem IC eine Abgleichschaltung parallel geschaltet. Es lässt sich dadurch ein Abgleich erreichen. Ferner lassen sich dadurch die Anzahl der Windungen für die Spule minimieren, um so wiederum einen hohen Ansprechabstand zu erhalten.

Die nachfolgende Beschreibung bevorzugter Ausführungsformen dient im Zusammenhang mit der Zeichnung der näheren Erläuterung der Erfindung. Es zeigen:
- Figur 1: eine schematische Darstellung eines Ausführungsbeispiels einer Datenträger-/Sendevorrichtung, welche nicht unter die Ansprüche fällt;
- Figur 2: eine Teildarstellung der Datenträger-/Sendevorrichtung gemäß Figur 1;
- Figur 3: eine Teildarstellung einer elektrischen Schaltungsanordnung der Datenträger-/Sendevorrichtung gemäß Figur 1;
- Figur 4: eine perspektivische Darstellung eines Ausführungsbeispiels einer erfindungsgemäßen Datenträger-/Sendevorrichtung;

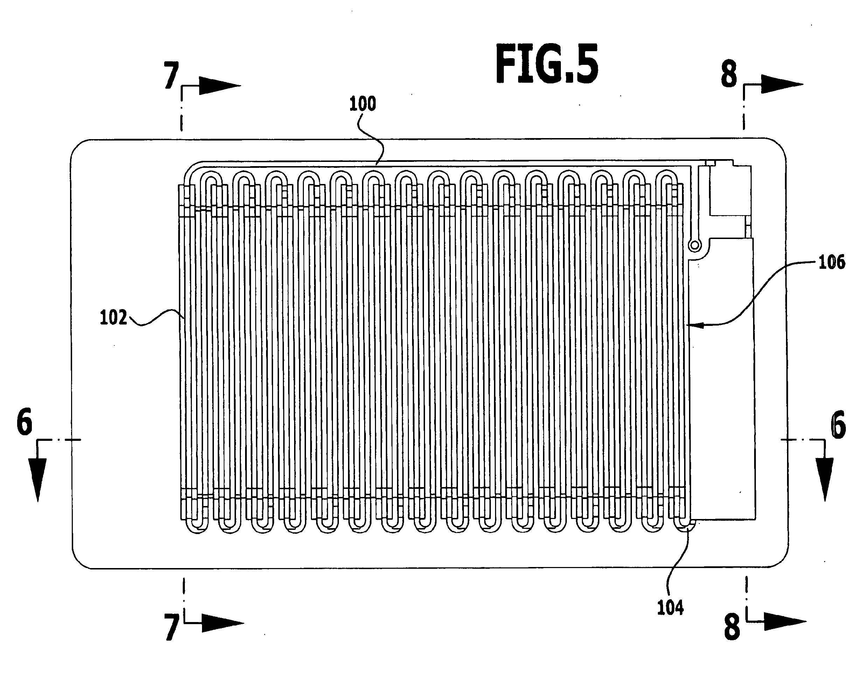

- Figur 5: eine Draufsicht auf die Datenträger-/Sendevorrichtung gemäß Figur 4;

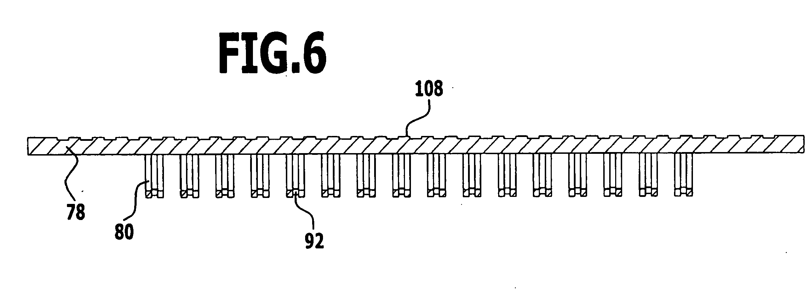

- Figur 6: eine Schnittansicht längs der Linie 6-6 gemäß Figur 5;

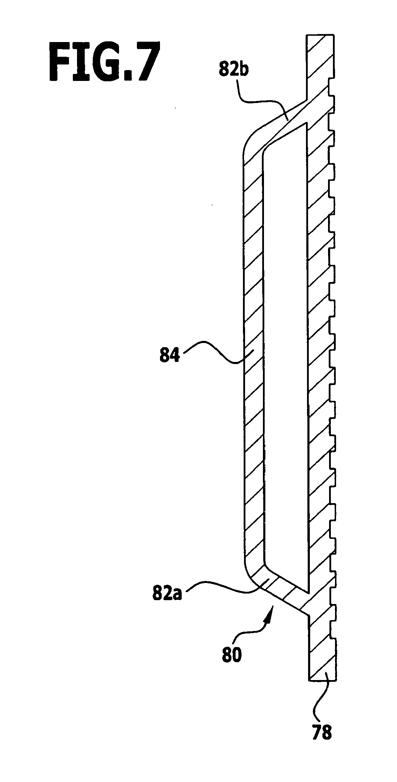

- Figur 7: eine Schnittansicht längs der Linie 7-7 gemäß Figur 5;

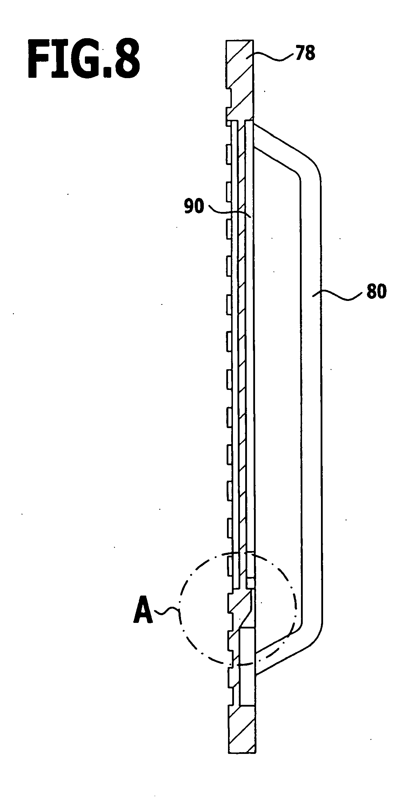

- Figur 8: eine Schnittansicht längs der Linie 8-8 gemäß Figur 5;

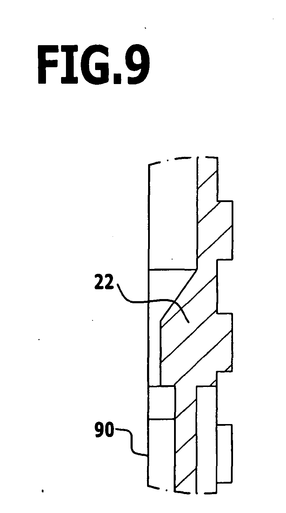

- Figur 9: eine vergrößerte Darstellung des Bereiches A gemäß Figur 8;
- Figur 10: eine Ansicht von unten der Datenträger-/Sendevorrichtung gemäß Figur 4; und
- Figur 11: eine ähnliche Ansicht wie Figur 10 bei einer Variante des zweiten Ausführungsbeispiels.

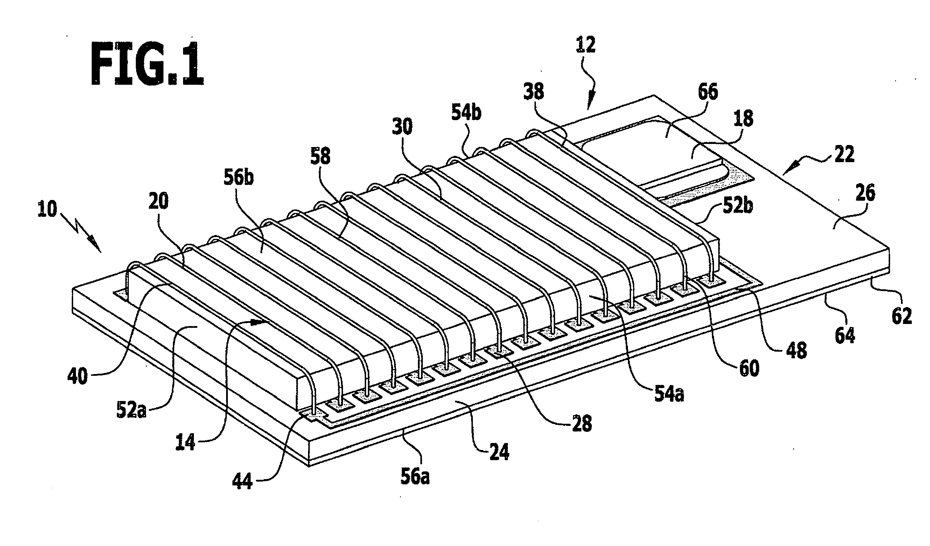

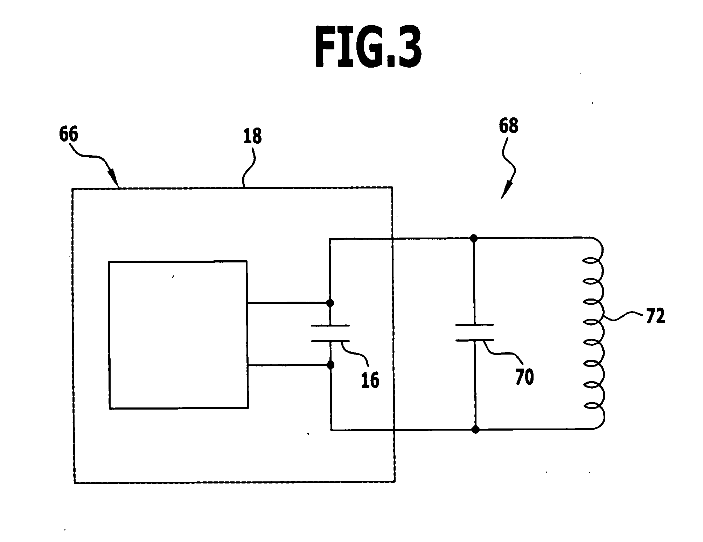

Ein Ausführungsbeispiel einer Datenträger-/Sendevorrichtung, welches in Figur 1 gezeigt und dort mit 10 bezeichnet ist, umfasst einen Schwingkreis 12 mit (mindestens) einer Spule 14 und (mindestens) einem Kondensator 16 (Figur 3). Der Kondensator 16 kann dabei ein diskretes Bauelement sein oder er kann in eine elektrische Schaltungsanordnung 18 integriert sein.

Die Spule 14 umfasst eine Mehrzahl von Windungen 20. Die Spule 14 ist an einem Träger 22 angeordnet, welcher einen Trägerkörper 24 umfasst. Der Trägerkörper 24 ist insbesondere als Platine ausgebildet und plattenförmig. Er weist eine Oberseite 26 auf, welche im Wesentlichen flach ist.

Die Windungen 20 der Spule 14 umfassen jeweils einen ersten Bereich 28, welcher an dem Trägerkörper 24 an dessen Oberseite 26 gebildet ist, und einen zweiten Bereich 30, welcher sich über den Trägerkörper 24 hinaus erstreckt und insbesondere oberhalb der Oberseite 26 des Trägerkörpers 24 angeordnet ist.

Die ersten Bereiche 28 der Windungen 20 der Spule 14 sind durch Leiterbahnen an dem Trägerkörper 24 gebildet. Die Leiterbahnen 32 liegen dabei insbesondere an der Oberseite 26.

Diese Leiterbahnen 32, welche die zweiten Bereiche 30 bilden, sind parallel beabstandet zueinander. Bei dem ersten Ausführungsbeispiel liegen die Leiterbahnen 32 leicht schräg zu einer Spulenachse 34. Die Achse 34 ist dabei parallel zu der Oberseite 26. Die Achse 34 liegt dabei insbesondere auf einer Mittelebene des Trägerkörpers 24, welche diesen mittig kreuzt.

Die jeweiligen Leiterbahnen 32, welche die jeweiligen ersten Bereiche 28 bilden, weisen ein erstes Anschlussfeld 36a und ein zweites Anschlussfeld 36b auf. Die Leiterbahnbereiche erstrecken sich zwischen dem ersten Anschlussfeld 36a und dem zweiten Anschlussfeld 36b. Die Anschlussfelder 36a, 36b sind beispielsweise rechteckig ausgestaltet und sind auf die gleiche Weise hergestellt wie die jeweiligen Leiterbahnen 32.

Die Spule 14 weist eine erste Windung 38 und eine letzte Windung 40 auf. (Die erste Windung 38 wird als diejenige Windung angesehen, welche der elektrischen Schaltungsanordnung 18 nächstliegend ist.) Zwischen der ersten Windung 38 und der letzten Windung 40 erstreckt sich die Spule 14. Die erste Windung 38 und die letzte Windung 40 sind äußere Windungen der Spule 14.

Der ersten Windung 38 ist ein Anschluss 42 in Form eines Anschlussfeldes zugeordnet. Der letzten Windung 40 ist ebenfalls ein Anschluss 44 in Form eines Anschlussfeldes zugeordnet.

Von dem Anschluss 42 führt eine Leiterbahn 46 zu der elektrischen Schaltungsanordnung 18. Weiterhin führt von dem Anschluss 44 eine Leiterbahn 48 zu der elektrischen Schaltungsanordnung 18. Die Leiterbahnen 46 und 48 sind dabei an dem Trägerkörper 24 und insbesondere an deren Oberseite 26 angeordnet. Sie sind insbesondere auf die gleiche Art und Weise hergestellt wie die Leiterbahnen 32, welche die ersten Bereiche 28 der Spule 14 bilden.

Die Leiterbahnen 46 und 48 und die Leiterbahnen 32 sind beispielsweise auf dem Trägerkörper 24 aufgedruckt. Sie sind flach ausgestaltet und ragen nicht über die Oberfläche des Trägerkörpers 24 hinaus.

Insbesondere sind die Leiterbahnen 46, 48 und 32 integral mit dem Trägerkörper 24 hergestellt. Beispielsweise wird eine entsprechende Trägerplatine durch Aufdrucken der Leiterbahnen hergestellt.

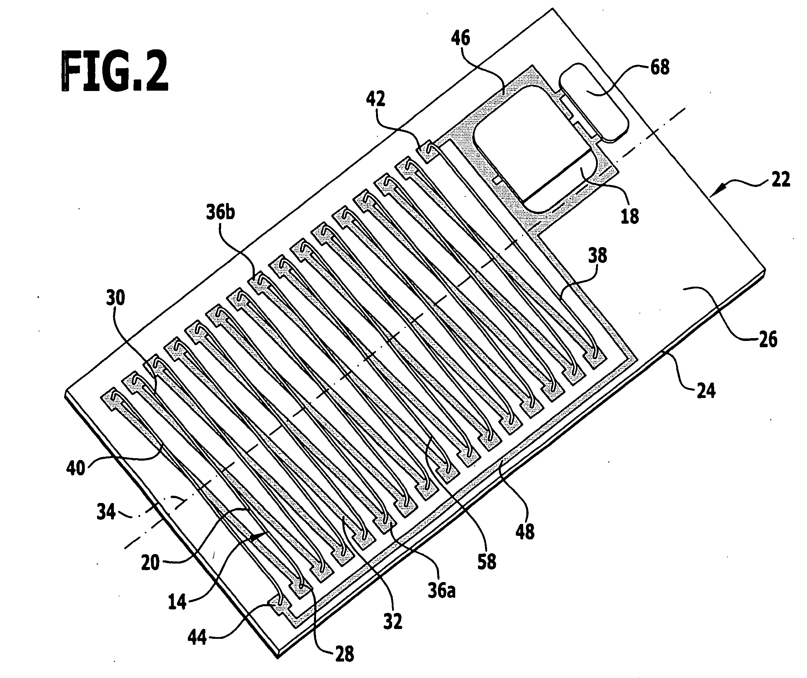

Auf dem Trägerkörper 24 sitzt, die ersten Bereiche 28 überdeckend, (mindestens) ein Spulenkernkörper 50. Der Spulenkernkörper 50 weist eine Mittelachse auf, welche im Wesentlichen konzentrisch zu der Achse 34 liegt. Der Spulenkernkörper 50 ist insbesondere quaderförmig ausgestaltet mit jeweils parallel gegenüberliegenden Seiten. Der Spulenkernkörper 50 weist dabei gegenüberliegende Stirnseiten 52a, 52b, gegenüberliegende Längsseiten 54a, 54b und eine gegenüberliegende Unterseite 56a und Oberseite 56b auf. (In Figur 2 ist der Spulenkernkörper 50 nicht gezeigt.)

Die Unterseite 56a des Spulenkernkörpers 50 liegt auf der Oberseite 26 des Trägerkörpers 24 auf.

Wenn der Spulenkernkörper 50 aus einem elektrisch leitenden Material ist, dann ist zwischen dem Spulenkernkörper 50 und den Leiterbahnen 32, 46, 48 ein isolierendes Material beispielsweise in Form einer Folie angeordnet. Es ist beispielsweise auch möglich, dass dann die Leiterbahnen 32, 42, 44 nicht an der Oberfläche des Trägerkörpers 24 liegen, sondern nach oben durch isolierendes Material abgedeckt sind. Es ist auch möglich, dass an dem Spulenkernkörper 50 eine elektrisch isolierende Folie angeordnet ist.

Der Spulenkernkörper 50 ist aus einem weichmagnetischen Material mit hoher magnetischer Permeabilität und niedrigem magnetischen Fluss hergestellt. Ein grundsätzlich geeignetes Material ist ein Ferritmaterial.

Beispielsweise ist der Spulenkernkörper 50 aus einem biegeflexiblen Material hergestellt. Er kann aus einem Folienmaterial hergestellt sein. Ein Beispiel eines solchen weichmagnetischen Folienmaterials ist das Material "LIQUALLOY" der ALPS ELECTRIC CO., LTD., 1 - 7, Yukigaya-otsuka-cho, Ota-ku, Tokio, 145-8501, Japan. Bei diesem Material handelt es sich um ein amorphes Metall.

Der zweite Bereich 30 der jeweiligen Windungen 20 ist durch einen Bonddraht 58 gebildet. Die Bondingverbindung des Bonddrahts 58 mit den jeweiligen ersten Bereichen 28 ist insbesondere durch Dickdrahtbondingverfahren erreicht.

Der Bonddraht 58 einer Windung verläuft zwischen den Anschlussfeldern 36a, 36b benachbarter erster Bereiche 28. Die Verbindung des entsprechenden Bonddrahts 58 mit den Anschlussfeldern 36a, 36b ist lotfrei und beispielsweise über Ultraschalldrahtbonden, Thermosonicbonden oder Thermokompressionsbonden hergestellt. Die Verbindung der Bonddrähte 58, welche den zweiten Bereich 30 der Spule 14 bilden, mit dem Trägerkörper 24 kann maschinell über eine Bondingmaschine hergestellt werden.

Bei dem gezeigten Ausführungsbeispiel laufen die Bonddrähte 58 im Wesentlichen senkrecht zu der Achse 34.

Ausgehend von dem Anschluss 42 verläuft ein Bonddraht zu einem Anschlussfeld 36a. Von dort läuft eine Leiterbahn 32 zu dem entsprechenden zweiten Anschlussfeld 36b, um den ersten Bereich 28 zu bilden. Es ist dann die erste Windung 38 gebildet usw. Die Verbindung zwischen dem ersten Bereich 28 und dem zweiten Bereich 30 dieser ersten Windung 38 erfolgt über Bonding.

Die nächstbenachbarte Windung ist dadurch gebildet, dass ausgehend von dem entsprechenden zweiten Anschlussfeld 36b ein Bonddraht zu dem nächsten Anschlussfeld 36a verläuft, welches nächstbenachbart zu dem ersten Anschlussfeld 36a der ersten Windung 38 ist. Von dort ausgehend wiederum verläuft eine Leiterbahn zur Bildung eines ersten Bereichs 28. Dadurch wiederum ist dann die zweite Windung gebildet.

Die Bonddrähte 58 stehen über der Oberseite 26 des Trägerkörpers 24 hinaus.

Auf diese Weise ist dann die Spule 14 bis zur letzten Windung 40 gebildet, wobei die letzte Windung 40 auch eine Halbwindung sein kann.

Die Bonddrähte 58 der zweiten Bereiche 30 der Spule 14 liegen auf der Oberseite 56b des Spulenkernkörpers 50 an. Zwischen dieser Oberseite 56b und den jeweiligen Anschlussfeldern 36a, 36b liegt jeweils eine Stufe 60 vor. Über diese Stufe 60 ist der jeweilige Bonddraht 58 zumindest näherungsweise parallel zu der jeweiligen Längsseite 54a, 54b geführt.

Die Bonddrähte 58 sind beispielsweise aus Kupfer oder Aluminium hergestellt. Aluminium ist vorteilhaft, um Stufen 60 zu ermöglichen.

Wenn der Spulenkernkörper 50 elektrisch leitend ist, dann können die Bonddrähte 58 eine elektrische Isolierung zu dem Spulenkernkörper hin aufweisen. Es ist auch möglich, dass der Spulenkernkörper 50 eine entsprechende elektrische Isolierung beispielsweise in Form einer Folie trägt.

Der Träger 22 umfasst eine Metallelementeinrichtung 62. Diese Metallelementeinrichtung ist Teil des Trägerkörpers 24 oder an dem Trägerkörper 24 angeordnet. Die Metallelementeinrichtung 62 ist beispielsweise plattenförmig oder folienförmig ausgebildet und deckt die Spule 14 mindestens teilweise zu einer Anwendung hin ab. Bei der Datenträger-/Sendevorrichtung 10 wird der Träger 22 mit einer der Spule 14 abgewandten Rückseite an der Anwendung fixiert. Dementsprechend bildet die Metallelementeinrichtung 62 eine Rückseite des Trägers 22.

Die Metallelementeinrichtung 62 weist als metallisches Material beispielsweise (Edel-)Stahl, Aluminium oder Kupfer auf.

Der Träger 22 ist im Wesentlichen plattenförmig ausgebildet und weist vorzugsweise eine ebene Rückseite 64 auf.

Die elektrische Schaltungsanordnung 18 ist an dem Träger 22 angeordnet. Die elektrische Schaltungsanordnung 18 ist insbesondere eine integrierte Schaltungsanordnung, welche durch einen IC 66 gebildet ist, und beispielsweise den Kondensator 16 umfasst. Die Schwingkreiskapazität liegt beispielsweise in einem Bereich zwischen 20 pF bis 100 pF.

Es kann dabei vorgesehen sein, dass mit dem IC 66 eine Abgleichschaltung 68 elektrisch verbunden ist (insbesondere parallel geschaltet ist) und an dem Träger 22 angeordnet ist. Diese umfasst insbesondere einen oder mehrere Kondensatoren 70 und eine oder mehrere Spulen 72. Sie ist mit dem Kondensator 70 und der Spule 72 parallel zu der Kapazität 16 der elektrischen Schaltungsanordnung 18 geschaltet. Über sie lässt sich ein Abgleich erreichen. Außerdem lässt sich die Anzahl der Windungen 20 durch das Vorsehen einer Abgleichschaltung 68 geringer halten.

Insbesondere ist die Anzahl der Windungen 20 höchstens zehn. Es lässt sich beispielsweise eine Datenträger-/Sendevorrichtung mit sechs Windungen realisieren.

Die elektrische Schaltungsanordnung 18 umfasst weitere Komponenten zur Ansteuerung des Schwingkreises 12.

Die Datenträger-/Sendevorrichtung 10 wird wie folgt hergestellt:

Es wird ein Träger 22 mit dem Trägerkörper 24 und den Leiterbahnen 32, 40, 42 hergestellt. Die Leiterbahnen 32, 44, 46 werden durch Oberflächenbearbeitung und insbesondere durch Aufdrucken hergestellt. Falls notwendig, kann über diese Leiterbahnen eine weitere Schicht beispielsweise in Form einer Folie aufgebracht werden. Es wird dann der Spulenkernkörper 50 an dem Trägerkörper 24 beispielsweise durch Aufkleben fixiert.

Anschließend werden die zweiten Bereiche 30 der Spule 14 durch Bonding hergestellt. Bonddrähte 58 werden an den entsprechenden Anschlussfeldern 36a, 36b fixiert, um die Windungen 20 der Spule 14 herzustellen.

Zur Herstellung der zweiten Bereiche 30 wird insbesondere eine Bondingmaschine verwendet. Die Verbindung der Bonddrähte 58 mit dem Trägerkörper 24 ist dabei lötstellenfrei.

Eine Grundplatte des Trägers 22 ist beispielsweise aus Aluminium hergestellt.

Die Datenträger-/Sendevorrichtung 10 funktioniert wie folgt:

Die Spule 14 ist durch die Metallelementeinrichtung 62 zu einer Anwendung hin gegenüber abgedeckt. Die Metallelementeinrichtung weist insbesondere eine Breite auf, welche mindestens so breit ist wie die Spule 14, und weist ferner eine Länge auf, welche mindestens so lang ist wie die Spule 14.

Die Datenträger-/Sendevorrichtung 10 ist insbesondere eine RFID-Datenträgervorrichtung (RFID - Radio Frequency Identification). Der Schwingkreis 12 mit der elektrischen Schaltungsanordnung 18 bildet einen Transponder. Zum Lesen und gegebenenfalls zum Speichern von Daten in der Datenträger-/Sendevorrichtung 10 wird eine Lese-Empfangs-Einrichtung mit einem Lesekopf verwendet (in der Zeichnung nicht gezeigt). Die Datenübertragung zwischen Lese-Empfangs-Einrichtung und der Datenträger-/Sendevorrichtung 10 erfolgt elektromagnetisch berührungslos. Die Datenträger-/Sendevorrichtung 10 erhält ihre Energie zur Datenübertragung an die Lese-Empfangs-Einrichtung von Letzterer. Der Schwingkreis 12 bildet eine Antenne (Transponder-Antenne). In der Spule 14 wird durch das elektromagnetische Anregungsfeld der Lese-Empfangs-Einrichtung ein Induktionsstrom induziert. Dieser aktiviert die elektrische Schaltungsanordung 18.

Beispielsweise handelt es sich bei der Datenträger-/Sendevorrichtung um einen passiven Transponder. Bei diesem wird die Kapazität des Schwingkreises 12 aufgeladen, um für die Stromversorgung der elektrischen Schaltungsanordnung 18 zu sorgen. Bei aktivierter Schaltungsanordnung 18 kann diese Befehle von der Lese-Empfangs-Einrichtung empfangen bzw. sie kann Daten an die Lese-Empfangs-Einrichtung senden. Dieses Senden erfolgt beispielsweise durch Lastmodulation, das heißt Veränderung des elektromagnetischen Feldes, welche durch die Lese-Empfangs-Einrichtung abgestrahlt wird. Diese Veränderung wiederum kann durch die Lese-Empfangs-Einrichtung detektiert werden.

Beispielsweise ist die Datenträger-/Sendevorrichtung als Nahfeld-Datenträger-/Sendevorrichtung ausgebildet. Die unverschobene Schwingkreisfrequenz (siehe unten) liegt beispielsweise bei ca. 13,56 MHz oder im Bereich zwischen 125 kHz und 135 kHz.

Durch das Vorsehen der Metallelementeinrichtung 62 ist die Datenträger-/Sendevorrichtung 10 zur Verwendung an einem metallischen Objekt geeignet. Durch die Metallelementeinrichtung 62 wird die Resonanzfrequenz des Schwingkreises 12 verschoben und zwar üblicherweise auf eine höhere Frequenz. Es wird dadurch eine definierte "intrinsische" Resonanzfrequenzverschiebung erzeugt. Der Einfluss des metallischen Objekts, an welchem die Datenträger-/Sendevorrichtung 10 angeordnet ist, ist dadurch stark reduziert. Durch die Metallelementeinrichtung 62 wird also eine Resonanzfrequenz des Schwingkreises 12 eingestellt, welche gegenüber der Resonanzfrequenz des Schwingkreises ohne Metallelementeinrichtung 62 modifiziert ist und insbesondere oberhalb dieser liegt. Dadurch ist aber der Einfluss eines metallischen Objekts (wie beispielsweise eines Motorblocks), an dem die Datenträger-/Sendevorrichtung 10 fixiert ist, stark reduziert, das heißt die externe Veränderung der Resonanzfrequenz durch das externe Objekt ist stark verringert.

Bezüglich des Einflusses einer Metallelementeinrichtung wird auf die nicht vorveröffentlichte deutsche Patentanmeldung Nr. 10 2006 017 992.7 vom 7. April 2006 der gleichen Anmelderin verwiesen.

Die erfindungsgemäße Datenträger-/Sendevorrichtung 10 lässt sich auf einfache und kostengünstige Weise mit den erforderlichen Eigenschaften herstellen. Die Herstellung lässt sich mit geringen Fertigungstoleranzen durchführen.

Es ist beispielsweise nicht notwendig, Drahtenden zu fangen. Es wird keine Wickelmaschine benötigt. Die Anzahl der Prozesschritte lässt sich minimieren. Weiterhin erhält man eine hohe Reproduzierbarkeit.

Durch die erfindungsgemäße Lösung lässt sich die 3D-Spule 14 durch 2D-Verfahren, nämlich durch Oberflächenbearbeitung zur Herstellung der Leiterbahnen 32 und durch Bonding der zweiten Bereiche 30 herstellen.

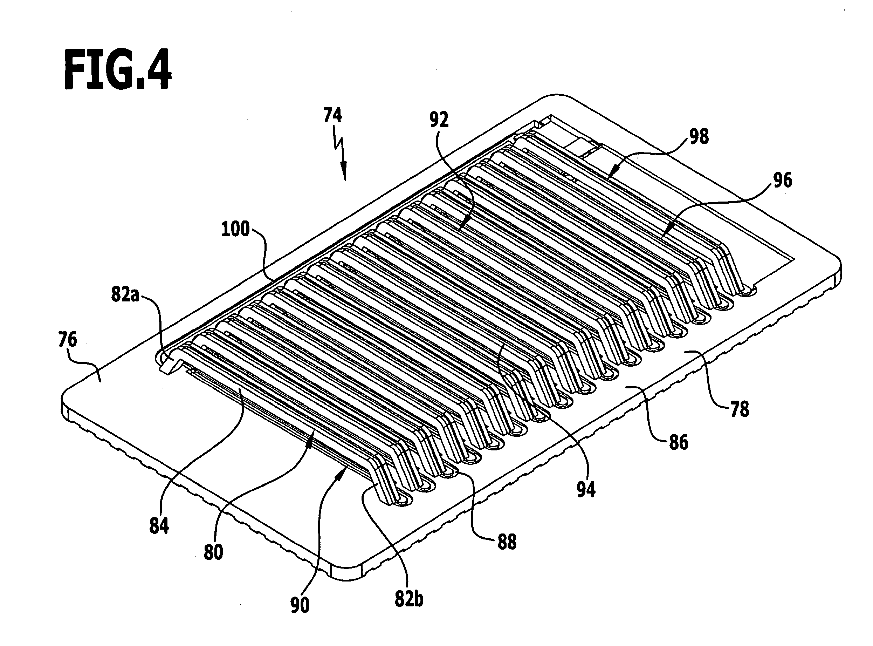

Ein Ausführungsbeispiel einer erfindungsgemäßen Datenträger-/Sendevorrichtung, welches in Figur 4 gezeigt und dort mit 74 bezeichnet ist, umfasst wiederum einen Träger 76 mit einem Trägerkörper 78.

An dem Trägerkörper 78 sind eine Mehrzahl von parallel beabstandeten Brücken 80 angeordnet. Diese Brücken 80 weisen jeweils gegenüberliegende Brückenfüße 82a, 82b auf, zwischen welchen ein Stegelement 84 liegt. Das Stegelement 84 ist dabei einstückig mit den Brückenfüßen 82a, 82b verbunden. Über die Brückenfüße 82a, 82b sind die Brücken 80 mit dem Trägerkörper 78 verbunden, wobei ein Zwischenraum zwischen den Stegelementen 84 und dem Trägerkörper gebildet ist.

Die Brücken 80 sind insbesondere einstückig mit dem Trägerkörper 78 verbunden. Der Trägerkörper 78 mit den Stegelementen 84 ist vorzugsweise über ein Spritzgussverfahren hergestellt.

An dem Trägerkörper 78 sind auf einer Oberseite 86 Leiterbahnen 88 hergestellt, welche an der Oberseite 86 des Trägerkörpers 78 verlaufen und erste Bereiche 90 entsprechend den ersten Bereichen 28 der Datenträger-/Sendevorrichtung 10 bilden.

Zweite Bereiche 92 von Leiterbahnen 94 sind an den Brücken 80 gebildet, welche Trägerelement für diese Leiterbahnen 34 sind.

Ein zugehöriger erster Bereich 90 und zweiter Bereich 92 bilden eine Windung 96 einer Spule 98. Die Spule 98 ist wiederum die Spule eines Schwingkreises, welcher mit einer elektrischen Schaltungsanordnung verbunden ist.

Entsprechend ist an dem Trägerkörper 78 eine Leiterbahn 100 gebildet, welche zu einer letzten Windung 102 führt, und es ist eine Leiterbahn 104 gebildet, welche zu einer ersten Windung 106 führt.

Die Leiterbahnen 88, 94, 100 und 104 sind an dem Trägerkörper 78 und an den Brücken 80 durch Oberflächenbearbeitung hergestellt.

Insbesondere handelt es sich bei dem Trägerkörper 78 mit den Brücken 80 um einen räumlich spritzgegossenen Schaltungsträger (MID - Molded Interconnected Device), welcher aus einem Material hergestellt ist, an welchem durch Laseraktivierung Leiterbahnen herstellbar sind.

Nach Herstellung des Trägerkörpers 78 mit den Brücken 80 wird das entsprechende Element durch einen Laserstrahl definiert abgetastet, um die Leiterbahnen 88, 94, 100, 104 zu erzeugen. Dadurch wird die Spule 98 mit ihren Windungen 96 hergestellt.

Die zweiten Bereiche 92 der Windungen 96 erheben sich mittels der Anordnung auf den Brücken 80 über den Trägerkörper 78. Die ersten Bereiche 90 der Windungen 96 sind an dem Trägerkörper 78 gebildet.

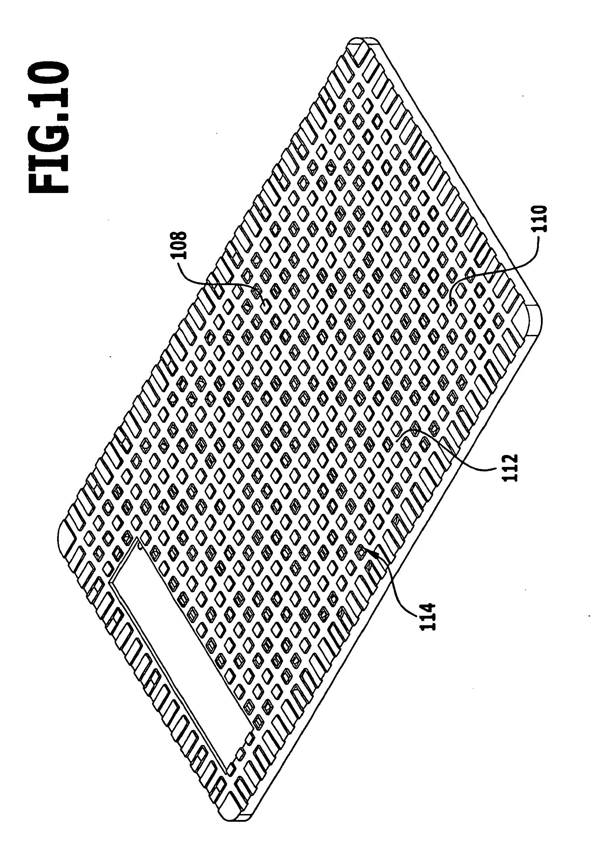

An einer Rückseite 108 (Figur 10) des Trägerkörpers 78 sind eine Mehrzahl von beabstandeten Feldern 110 angeordnet. Zwischen den Feldern liegen Kanäle 112. Die Felder 110 sind metallisiert. Mittels ihnen wird eine Metallelementeinrichtung 114 gebildet, welche der Funktionsweise der Metallelementeinrichtung 62 der Datenträger-/Sendevorrichtung 10 entspricht.

Die Rückseite 108 des Trägerkörpers 78 ist dadurch nicht vollflächig metallisiert, sondern nur auf den Feldern 110. Die Kanäle 112 und die Felder 110 sind dabei so dimensioniert, dass die erforderliche Resonanzfrequenzverschiebung des entsprechenden Schwingkreises, welcher die Spule 98 umfasst, erhalten wird.

Wenn leitfähige Bereiche zur Herstellung der Metallelementeinrichtung 114 durch Laseraktivierung hergestellt werden, dann ist die Herstellung der Metallelementeinrichtung 114 erleichtert, wenn nur "diskrete" Felder 110 aktiviert werden müssen und nicht die Rückseite 108 vollflächig aktiviert werden muss.

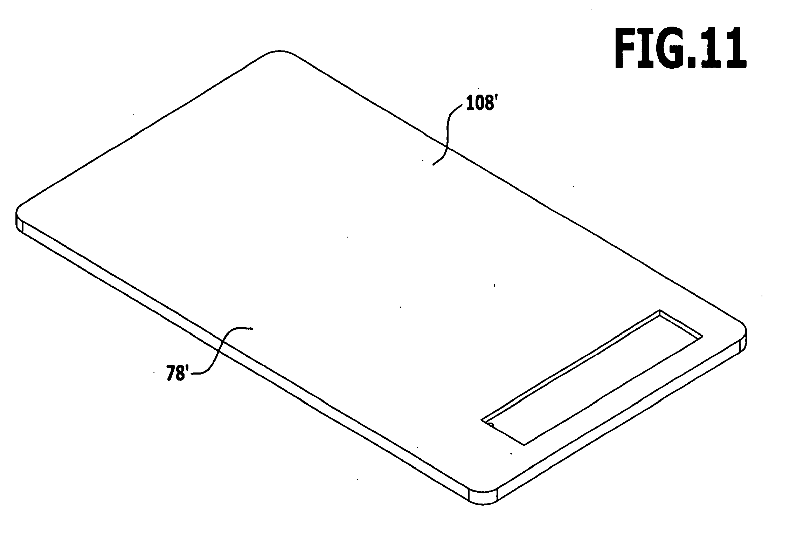

Es ist aber grundsätzlich auch möglich, wie in Figur 11 für eine Variante 78' des Trägerkörpers angedeutet, dass eine Rückseite 108' vollflächig metallisiert ist, indem diese beispielsweise mit einer Kupferfolie oder Aluminiumfolie versehen ist oder entsprechend Kupfer bzw. Aluminium abgeschieden ist.

Insbesondere ist zwischen die Brücken 80 und der Oberseite 86 des Trägerkörpers 78 ein Spulenkernkörper eingeschoben. (In der Zeichnung nicht gezeigt.) Dieser hat die gleiche Funktion wie der Spulenkernkörper 50.

Die Datenträger-/Sendevorrichtung 74 funktioniert gleich wie die Datenträger-/Sendevorrichtung 10.

## Patentansprüche

1. Datenträger-/Sendevorrichtung, umfassend
- einen Schwingkreis (12) mit mindestens einer Spule (98) mit einer Mehrzahl von Windungen (96),
- einen Träger (76) für die Spule (98) mit einem Trägerkörper (78), und
- eine elektrische Schaltungsanordnung (18), an welche die mindestens eine Spule (98) gekoppelt ist,
- wobei die Windungen (96) der Spule (98) jeweils einen ersten Bereich (90) aufweisen, welcher an dem Trägerkörper (78) an dessen Oberseite (86) gebildet ist, und einen zweiten Bereich (92) aufweisen, welcher über den Trägerkörper (78) hinausragt und oberhalb der Oberseite (86) angeordnet ist, und wobei ein erster Bereich (90) und der zugeordnete zweite Bereich (92) einer Windung (96) elektrisch leitend miteinander verbunden sind und ein erster Bereich (90) einer Windung (96) mit dem zweiten Bereich (92) einer benachbarten Windung elektrisch leitend verbunden ist,
**dadurch gekennzeichnet, dass**
- an dem Trägerkörper (78) Brücken (80) einstückig gebildet sind, an welchen die zweiten Bereiche (92) angeordnet oder gebildet sind, wobei eine Brücke (80) jeweils gegenüberliegende Brückenfüße (82a, 82b) und ein zwischen den Brückenfüßen (82a, 82b) liegendes und mit diesen verbundenes Stegelement (84) aufweist,
- die Brücke (80) über die Brückenfüße (82a, 82b) mit dem Trägerkörper (78) verbunden ist und
- ein Zwischenraum zwischen dem Stegelement (84) und dem Trägerkörper (78) gebildet ist.

2. Datenträger-/Sendevorrichtung nach Anspruch 1, **dadurch gekennzeichnet, dass** ein zweiter Bereich (92) der Windung (96), deren erster Bereich (90) mit einer benachbarten Windung elektrisch leitend verbunden ist, mit dem ersten Bereich (90) einer weiteren benachbarten Windung elektrisch leitend verbunden ist.

3. Datenträger-/Sendevorrichtung nach einem der vorangehenden Ansprüche, **dadurch gekennzeichnet, dass** die ersten Bereiche (90) in Form von Leiterbahnen (88) auf dem Trägerkörper (78) gebildet sind.

4. Datenträger-/Sendevorrichtung nach einem der vorangehenden Ansprüche, **dadurch gekennzeichnet, dass** die Oberseite (86) flach ist.

5. Datenträger-/Sendevorrichtung nach einem der vorangehenden Ansprüche, **dadurch gekennzeichnet, dass** die ersten Bereiche (90) durch Oberflächenbearbeitung an dem Trägerkörper (78) hergestellt sind.

6. Datenträger-/Sendevorrichtung nach Anspruch 5, **dadurch gekennzeichnet, dass** die ersten Bereiche gedruckt sind.

7. Datenträger-/Sendevorrichtung nach Anspruch 5, **dadurch gekennzeichnet, dass** die ersten Bereiche (90) durch Laseraktivierung hergestellt sind.

8. Datenträger-/Sendevorrichtung nach einem der vorangehenden Ansprüche, **dadurch gekennzeichnet, dass** an dem Trägerkörper (78) eine oder mehrere Leiterbahnen (94, 100) zum Anschluss an äußere Windungen (102, 106) angeordnet sind.

9. Datenträger-/Sendevorrichtung nach einem der vorangehenden Ansprüche, **dadurch gekennzeichnet, dass** an dem Trägerkörper (78) eine oder mehrere Leiterbahnen (94, 100) zur Verbindung der mindestens einen Spule (72) mit der elektrischen Schaltungsanordnung (18) angeordnet sind.

10. Datenträger-/Sendevorrichtung nach einem der vorangehenden Ansprüche, **dadurch gekennzeichnet, dass** die ersten Bereiche (90) parallel beabstandet sind.

11. Datenträger-/Sendevorrichtung nach einem der vorangehenden Ansprüche, **dadurch gekennzeichnet, dass** die ersten Bereiche jeweils mindestens ein erstes Anschlussfeld umfassen.

12. Datenträger-/Sendevorrichtung nach einem der vorangehenden Ansprüche, **dadurch gekennzeichnet, dass** an dem Trägerkörper (78) mindestens ein Spulenkernkörper (50) angeordnet ist.

13. Datenträger-/Sendevorrichtung nach Anspruch 12, **dadurch gekennzeichnet, dass** der mindestens eine Spulenkernkörper (50) quaderförmig ist.

14. Datenträger-/Sendevorrichtung nach Anspruch 12 oder 13, **dadurch gekennzeichnet, dass** der mindestens eine Spulenkernkörper (50) auf den Trägerkörper (24) aufgeklebt ist.

15. Datenträger-/Sendevorrichtung nach einem der vorangehenden Ansprüche, **dadurch gekennzeichnet, dass** die zweiten Bereiche (92) durch Laseraktivierung hergestellt sind.

16. Datenträger-/Sendevorrichtung nach einem der vorangehenden Ansprüche, **dadurch gekennzeichnet, dass** der Trägerkörper (78) durch Spritzgießen hergestellt ist.

17. Datenträger-/Sendevorrichtung nach einem der vorangehenden Ansprüche, **dadurch gekennzeichnet, dass** der Trägerkörper (24; 78) plattenförmig ausgebildet ist.

18. Datenträger-/Sendevorrichtung nach einem der vorangehenden Ansprüche, **dadurch gekennzeichnet, dass** der Träger (76) eine Metallelementeinrichtung (114) aufweist, welche die mindestens eine Spule (98) zu einem Objekt hin abdeckt, wenn der Träger (76) an dem Objekt fixiert ist.

19. Datenträger-/Sendevorrichtung nach Anspruch 18, **dadurch gekennzeichnet, dass** die Metallelementeinrichtung (62) plattenförmig oder folienförmig ist.

20. Datenträger-/Sendevorrichtung nach Anspruch 18, **dadurch gekennzeichnet, dass** die Metallelementeinrichtung (114) ein Feld (110) von beabstandeten metallischen Bereichen aufweist.

21. Datenträger-/Sendevorrichtung nach einem der vorangehenden Ansprüche, **dadurch gekennzeichnet, dass** eine Rückseite des Trägers (76), welche von der mindestens einen Spule (98) abgewandt ist, mindestens teilweise metallisch ist.

22. Datenträger-/Sendevorrichtung nach einem der vorangehenden Ansprüche, **dadurch gekennzeichnet, dass** die mindestens eine Spule (98) höchstens zehn Windungen (96) aufweist.

23. Datenträger-/Sendevorrichtung nach einem der vorangehenden Ansprüche, **dadurch gekennzeichnet, dass** eine Windungsachse (38) der mindestens einen Spule (98) parallel zu einer Oberseite (26; 86) des Trägerkörpers (78) ist.

24. Datenträger-/Sendevorrichtung nach einem der vorangehenden Ansprüche, **dadurch gekennzeichnet, dass** die elektrische Schaltungsanordnung (18) einen IC (66) umfasst.

25. Datenträger-/Sendevorrichtung nach Anspruch 24, **dadurch gekennzeichnet, dass** dem IC (66) eine Abgleichschaltung (68) parallel geschaltet ist.

## Claims

1. Data carrier/transmitter apparatus, comprising
- an oscillating circuit (12) having at least one coil (98) having a plurality of windings (96),
- a carrier (76) for the coil (98), the carrier (76) having a carrier body (78), and
- an electrical circuit arrangement (18) to which the at least one one coil (98) is coupled,
- wherein the windings (96) of the coil (98) each have a first region (90) which is formed on the carrier body (78) on the upper side (86) thereof, and a second region (92) which projects beyond the carrier body (78) and is arranged above the upper side (86), and wherein a first region (90) and the associated second region (92) of a winding (96) are electrically conductively connected to each other, and a first region (90) of a winding (96) is electrically conductively connected to the second region (92) of an adjacent winding (96),
**characterized in that**
- formed integrally in one piece on the carrier body (78) are bridges (80) on which the second regions (92) are arranged or formed, wherein a bridge (80) in each case has opposed bridge legs (82a, 82b) and a web element (84) located between and connected to the bridge legs (82a, 82b),
- the bridge (80) is connected by the bridge legs (82a, 82b) to the carrier body (78), and
- an interspace is formed between the web element (84) and the carrier body (78).

2. Data carrier/transmitter apparatus in accordance with claim 1, **characterized in that** a second region (92) of the winding (96) which has its first region (90) electrically conductively connected to an adjacent winding is electrically conductively connected to the first region (90) of another adjacent winding.

3. Data carrier/transmitter apparatus in accordance with any one of the preceding claims, **characterized in that** the first regions (90) are formed on the carrier body (78) in the form of conductive traces (88).

4. Data carrier/transmitter apparatus in accordance with any one of the preceding claims, **characterized in that** the upper side (86) is flat.

5. Data carrier/transmitter apparatus in accordance with any one of the preceding claims, **characterized in that** the first regions (90) are produced by surface processing the carrier body (78).

6. Data carrier/transmitter apparatus in accordance with claim 5, **characterized in that** the first regions are produced by printing.

7. Data carrier/transmitter apparatus in accordance with claim 5, **characterized in that** the first regions (90) are created by laser activation.

8. Data carrier/transmitter apparatus in accordance with any one of the preceding claims, **characterized in that** the carrier body (78) has arranged thereon one or more conductive traces (94, 100) for connecting to outer windings (102, 106).

9. Data carrier/transmitter apparatus in accordance with any one of the preceding claims, **characterized in that** the carrier body (78) has arranged thereon one or more conductive traces (94, 100) for connecting the at least one coil (72) to the electrical circuit arrangement (18).

10. Data carrier/transmitter apparatus in accordance with any one of the preceding claims, **characterized in that** the first regions (90) are arranged in parallel spaced relation.

11. Data carrier/transmitter apparatus in accordance with any one of the preceding claims, **characterized in that** the first regions each comprise at least a first terminal field.

12. Data carrier/transmitter apparatus in accordance with any one of the preceding claims, **characterized in that** the carrier body (78) has at least one coil core body (50) arranged thereon.

13. Data carrier/transmitter apparatus in accordance with claim 12, **characterized in that** the at least one coil core body (50) is of cuboid shape.

14. Data carrier/transmitter apparatus in accordance with claim 12 or 13, **characterized in that** the at least one coil core body (50) is adhesively bonded to the carrier body (24).

15. Data carrier/transmitter apparatus in accordance with any one of the preceding claims, **characterized in that** the second regions (92) are created by laser activation.

16. Data carrier/transmitter apparatus in accordance with any one of the preceding claims, **characterized in that** the carrier body (78) is produced by injection moulding.

17. Data carrier/transmitter apparatus in accordance with any one of the preceding claims, **characterized in that** the carrier body (24; 78) is of plate-like configuration.

18. Data carrier/transmitter apparatus in accordance with any one of the preceding claims, **characterized in that** the carrier (76) has a metal element device (114) which covers the at least one coil (98) against an object when the carrier (76) is fixed to the object.

19. Data carrier/transmitter apparatus in accordance with claim 18, **characterized in that** the metal element device (62) is of plate-like or foil-like configuration.

20. Data carrier/transmitter apparatus in accordance with claim 18, **characterized in that** the metal element device (114) has a field (110) of spaced-apart metallic regions.

21. Data carrier/transmitter apparatus in accordance with any one of the preceding claims, **characterized in that** a back side of the carrier (76) facing away from the at least one coil (98), is at least partially metallic.

22. Data carrier/transmitter apparatus in accordance with any one of the preceding claims, **characterized in that** the at least one coil (98) has a maximum of ten windings (96).

23. Data carrier/transmitter apparatus in accordance with any one of the preceding claims, **characterized in that** a winding axis (38) of the at least one coil (98) is parallel to an upper side (26; 86) of the carrier body (78).

24. Data carrier/transmitter apparatus in accordance with any one of the preceding claims, **characterized in that** the electrical circuit arrangement (18) comprises an IC (66).

25. Data carrier/transmitter apparatus in accordance with claim 24, **characterized in that** the IC (66) has a trim circuit (68) connected in parallel thereto.

## Revendications

1. Dispositif de support de données/d'émission, comprenant
- un circuit oscillant (12) avec au moins une bobine (98) comprenant une pluralité de spires (96),
- un support (76) pour la bobine (98) comprenant un corps de support (78),
et
- un circuit électrique (18) sur lequel au moins la bobine (98) est couplée,
- dans lequel les spires (96) de la bobine (98) présentent respectivement une première zone (90) formée sur le dessus (86) du corps de support (78), et une deuxième zone (92) qui dépasse du corps de support (78) et qui est disposée au-dessus du dessus (86) et dans lequel une première zone (90) et la deuxième zone (92) affectée d'une spire (96) sont reliées électriquement entre elles et une première zone (90) d'une spire (96) est reliée électriquement à la deuxième zone (92) d'une spire voisine,
**caractérisé en ce que**
- sur le corps de support (78), des ponts (80) d'un seul tenant sont formés, sur lesquels les deux zones (92) sont disposées et formées, un pont (80) présentant des pieds de pont (82a, 82b) se faisant face et une entretoise (84) est située entre les pieds de pont (82a, 82b) et reliée à ceux-ci,
- le pont (80) est relié au corps de support (78) par les pieds de pont (82a, 82b) et
- un espace est formé entre l'entretoise (84) et le corps de support (78).

2. Dispositif de support de données/d'émission selon la revendication 1, **caractérisé en ce qu'**une deuxième zone (92) de la spire (96), dont la première zone (90) est reliée de façon électriquement conductrice à une spire voisine, est reliée de façon électriquement conductrice à la première zone (90) d'une autre spire voisine.

3. Dispositif de support de données/d'émission selon l'une quelconque des revendications précédentes, **caractérisé en ce que** les premières zones (90) sont formées par des pistes conductrices (88) sur le corps de support (78).

4. Dispositif de support de données/d'émission selon l'une quelconque des revendications précédentes, **caractérisé en ce que** le dessus (86) est plat.

5. Dispositif de support de données/d'émission selon l'une quelconque des revendications précédentes, **caractérisé en ce que** les premières zones (90) sont fabriquées par traitement de surface sur le corps de support (78).

6. Dispositif de support de données/d'émission selon la revendication 5, **caractérisé en ce que** les premières zones sont imprimées.

7. Dispositif de support de données/d'émission selon la revendication 5, **caractérisé en ce que** les premières zones (90) sont fabriquées par activation laser.

8. Dispositif de support de données/d'émission selon l'une quelconque des revendications précédentes, **caractérisé en ce qu'**une ou plusieurs pistes conductrices (94, 100) sont disposées sur le corps de support (78) en vue du branchement à des spires extérieures (102, 106).

9. Dispositif de support de données/d'émission selon l'une quelconque des revendications précédentes, **caractérisé en ce qu'**une ou plusieurs pistes conductrices (94, 100) sont disposées sur le corps de support (78) afin de relier au moins une bobine (72) au circuit électrique (18).

10. Dispositif de support de données/d'émission selon l'une quelconque des revendications précédentes, **caractérisé en ce que** les premières zones (90) sont parallèles entre elles.

11. Dispositif de support de données/d'émission selon l'une quelconque des revendications précédentes, **caractérisé en ce que** les premières zones renferment au moins une première zone de raccordement.

12. Dispositif de support de données/d'émission selon l'une quelconque des revendications précédentes, **caractérisé en ce qu'**un corps de noyau de bobine (50) est disposé sur le corps de support (78).

13. Dispositif de support de données/d'émission selon la revendication 12, **caractérisé en ce qu'**au moins le corps de noyau de bobine (50) est de forme carrée.

14. Dispositif de support de données/d'émission selon l'une quelconque de la revendication 12 ou 13, **caractérisé en ce qu'**au moins le corps de noyau de bobine (50) est collé sur le corps de support (24).

15. Dispositif de support de données/d'émission selon l'une quelconque des revendications précédentes, **caractérisé en ce que** les deuxièmes zones (92) sont fabriquées par activation laser.

16. Dispositif de support de données/d'émission selon l'une quelconque des revendications précédentes, **caractérisé en ce que** le corps de support (78) est fabriqué par injection.

17. Dispositif de support de données/d'émission selon l'une quelconque des revendications précédentes, **caractérisé en ce que** le corps de support (24 ; 78) est en forme de plaque.

18. Dispositif de support de données/d'émission selon l'une quelconque des revendications précédentes, **caractérisé en ce que** le support (76) présente un dispositif à éléments métalliques (114) qui recouvre au moins une bobine (98) vers un objet lorsque le support (76) est fixé sur l'objet.

19. Dispositif de support de données/d'émission selon la revendication 18, **caractérisé en ce que** le dispositif à éléments métalliques (62) est en forme de plaque ou de film.

20. Dispositif de support de données/d'émission selon la revendication 18, **caractérisé en ce que** le dispositif à éléments métalliques (114) présente un champ (110) de zones métalliques à distance l'une de l'autre.

21. Dispositif de support de données/d'émission selon l'une quelconque des revendications précédentes, **caractérisé en ce qu'**un côté arrière du support (76), opposé à au moins une bobine (98), est au moins en partie métallique.

22. Dispositif de support de données/d'émission selon l'une quelconque des revendications précédentes, **caractérisé en ce qu'**au moins une bobine (98) présente au maximum dix spires (96).

23. Dispositif de support de données/d'émission selon l'une quelconque des revendications précédentes, **caractérisé en ce qu'**un axe de spire (38) d'au moins une bobine (98) est parallèle à un dessus (26 ; 86) du corps de support (78).

24. Dispositif de support de données/d'émission selon l'une quelconque des revendications précédentes, **caractérisé en ce que** le circuit électrique (18) renferme une IC (66).

25. Dispositif de support de données/d'émission selon la revendication 24, **caractérisé en ce qu'**un circuit d'équilibrage (68) est branché en parallèle à l'IC (66).
